# EUROPEAN PATENT APPLICATION

(11) **EP 4 776 626 A1**
(43) Date of publication of application: **15.07.2026**
(21) Application number: 25224191.4
(22) Date of filing: 17.12.2025
(51) Int. Cl.: H04N 21/234, G06F 40/30, G06N 3/045, H04N 19/196, H04N 21/2343

(54) **METHOD AND SYSTEM FOR SEMANTIC COMMUNICATION WITH NETWORKED ARTIFICIAL INTELLIGENCE**

(30) Priority: 09.01.2025 IN 202521002122
(71) Applicant: Tata Consultancy Services Limited, Maharashtra (IN)
(72) Inventor: BHATTACHARYYA, Abhijan, 700160 Kolkata (IN); SAU, Ashis, 700160 Kolkata (IN); MAHATO, Suraj Kumar, 700160 Kolkata (IN)
(74) Representative: Goddar, Heinz J.

(57) **Abstract**

The embodiments of the present disclosure herein address unresolved problems of communication from the semantic aspects. Embodiments herein provide a method and system for a semantic communication with networked AI in sixth-generation technology for wireless communications (6G). Here, rather than encoding the input and transmitting the encoded symbols, the semantically relevant information is inferred from the input as per the context of the application and that information is encoded through conventional source encoding and transmitted. Conversion of the actual input to semantic information allows a huge reduction in the bandwidth requirement for the end-to-end channel. On the receiver side, these symbols are first decoded to extract semantic information. The semantic information is further used to predict the semantically relevant output to carry out the intended meaning at the receiver side.

## Description

### CROSS-REFERENCE TO RELATED APPLICATIONS AND PRIORITY

The present application claims priority to Indian application no. 202521002122, filed on January 9, 2025.

### TECHNICAL FIELD

The disclosure herein generally relates to the field of a semantic communication (SemCom) with a networked artificial intelligence (AI) in 6G, and more particularly, a method and system for semantic communication (SemCom) with networked AI in sixth-generation technology for wireless communications (6G).

### BACKGROUND

Sixth-generation technology for wireless communications (6G) promises a lot of exciting futuristic delay-sensitive low-latency interactive applications including extended reality (XR), robotics with embodied intelligence, intelligent Internet of Things (IoT) systems, etc. However, it is apprehended that the volume of data, especially for XR kind of applications, may become unmanageable by the ICT infrastructure and this will cause a severe degradation in latency contrary to the low-latency requirements. Also, given the data flow requirements of promised applications, it seems that the capacity needed by a communication channel may get severely constrained by Shannon's information theoretic limit.

However, over the years, artificial intelligence (AI) and machine learning (ML) has significantly evolved in terms of massively learning the attributes of different types of inputs, churning out relevant inference from a given input and, also, to predict outputs according to the inferences. Furthermore, 6G promises the future network to natively support AI functions as part of the AI native network (AINN) initiatives. This has renewed interest in addressing the problem of communication from the semantic aspects. This has led to the paradigm of semantic communication (SemCom).

### SUMMARY

Embodiments of the present disclosure present technological improvements as solutions to one or more of the above-mentioned technical problems recognized by the inventors in conventional systems. For example, in one embodiment, a method for semantic communication with networked AI in sixth-generation technology for wireless communications (6G) is provided. The processor-implemented method includes receiving, via an Input/Output (I/O) interface, a plurality of images of a predefined region from a user equipment to an edge, establishing, via the one or more hardware processors, a connection with an application server by sending the location information of the predefined region for a remote live visualization, and obtaining, via the one or more hardware processors, the location specific knowledgebase from the global knowledgebase through the application server via the established communication link.

Further, the processor-implemented method includes creating, via the one or more hardware processors, a semantic message from each of the plurality of images using the location specific knowledge base, wherein the sematic message is compressed using a predefined compression technique, fragmented into one or more packets as per a predefined maximum transmission unit, and the one or more packets are augmented with a sequence number and an image number.

Further, the processor-implemented method includes encoding, via the one or more hardware processors, the created sematic message for the received plurality of images by using an erasure block encoder, transmitting, via the one or more hardware processors, the encoded semantic message from the edge to the application server via the established communication link and from the application server to a receiver, and obtaining, via the one or more hardware processors, the time stamp and location coordinates of the predefined region from the encoded semantic message, wherein the encoded semantic message comprises the semantics of the remote scene.

Furthermore, the processor-implemented method includes verifying, via the one or more hardware processors, the obtained time stamp, location coordinates of the predefined region, and image number of each of the plurality images, decoding, via the one or more hardware processors, the received sematic message using an erasure block technique to verify whether a cyclic redundancy check is failed or not and rendering, via the one or more hardware processors, at least one of the plurality of images with associated information derived from the semantic message using a generative artificial intelligence (GenAI) service in a local edge computer equipped with the updated local knowledge base, wherein a text prompt is sent to the GenAI service to create the least one image using a diffusion technique and sends it to an observation unit.

In another embodiment, a system for semantic communication with networked AI in sixth-generation technology for wireless communications (6G) is provided. The system comprises a memory storing a plurality of instructions, one or more Input/Output (I/O) interfaces, and one or more hardware processors coupled to the memory via the one or more I/O interfaces. The one or more hardware processors are configured by the instructions to receive, via an Input/Output (I/O) interface, a plurality of images of a predefined region from a user equipment to an edge, wherein each of the plurality of images comprises of a time stamp and a location information of the predefined region, establish a connection with an application server by sending the location information of the predefined region for a remote live visualization and obtain the location specific knowledgebase from the global knowledgebase through the application server via the established communication link.

Further, the one or more hardware processors are configured by the instructions to create a semantic message from each of the plurality of images using the location specific knowledge base, wherein the sematic message is compressed using a predefined compression technique, fragmented into one or more packets as per a predefined maximum transmission unit, and the one or more packets are augmented with a sequence number and an image number.

Further, the one or more hardware processors are configured by the instructions to encode the created sematic message for the received plurality of images by using an erasure block encoder, transmit the encoded semantic message from the edge to the application server via the established communication link and from the application server to a receiver, and obtain the time stamp and location coordinates of the predefined region from the encoded semantic message, wherein the encoded semantic message comprises the semantics of the remote scene.

Furthermore, the one or more hardware processors are configured by the instructions to verify the obtained time stamp, location coordinates of the predefined region, and image number of each of the plurality images, decode the received sematic message using an erasure block technique to verify whether a cyclic redundancy check is failed or not and render at least one of the plurality of images with associated information derived from the semantic message using a generative artificial intelligence (GenAI) service in a local edge computer equipped with the updated local knowledge base, wherein a text prompt is sent to the GenAI service to create the least one image using a diffusion technique and sends it to an observation unit.

In yet another aspect, there are provided one or more non-transitory machine-readable information storage mediums comprising one or more instructions, which when executed by one or more hardware processors causes a method for a semantic communication with networked AI in sixth-generation technology for wireless communications (6G) is provided. The processor-implemented method includes receiving, via an Input/Output (I/O) interface, a plurality of images of a predefined region from a user equipment to an edge, establishing, via the one or more hardware processors, a connection with an application server by sending the location information of the predefined region for a remote live visualization, and obtaining, via the one or more hardware processors, the location specific knowledgebase from the global knowledgebase through the application server via the established communication link.

Further, the processor-implemented method includes creating, via the one or more hardware processors, a semantic message from each of the plurality of images using the location specific knowledge base, wherein the sematic message is compressed using a predefined compression technique, fragmented into one or more packets as per a predefined maximum transmission unit, and the one or more packets are augmented with a sequence number and an image number.

Further, the processor-implemented method includes encoding, via the one or more hardware processors, the created sematic message for the received plurality of images by using an erasure block encoder, transmitting, via the one or more hardware processors, the encoded semantic message from the edge to the application server via the established communication link and from the application server to a receiver, and obtaining, via the one or more hardware processors, the time stamp and location coordinates of the predefined region from the encoded semantic message, wherein the encoded semantic message comprises the semantics of the remote scene.

Furthermore, the processor-implemented method includes verifying, via the one or more hardware processors, the obtained time stamp, location coordinates of the predefined region, and image number of each of the plurality images, decoding, via the one or more hardware processors, the received sematic message using an erasure block technique to verify whether a cyclic redundancy check is failed or not and rendering, via the one or more hardware processors, at least one of the plurality of images with associated information derived from the semantic message using a generative artificial intelligence (GenAI) service in a local edge computer equipped with the updated local knowledge base, wherein a text prompt is sent to the GenAI service to create the least one image using a diffusion technique and sends it to an observation unit.

It is to be understood that both the foregoing general description and the following detailed description are exemplary and explanatory only and are not restrictive of the invention, as claimed.

### BRIEF DESCRIPTION OF THE DRAWINGS

The accompanying drawings, which are incorporated in and constitute a part of this disclosure, illustrate exemplary embodiments and, together with the description, serve to explain the disclosed principles:
FIG. 1 illustrates a block diagram of a system for a semantic communication with networked AI in sixth-generation technology for wireless communications (6G), according to some embodiments of the present disclosure.
FIG. 2 is a functional block diagram illustrating the system of FIG. 1 for semantic communication with networked AI in 6G, according to some embodiments of the present disclosure.
FIG. 3 is a schematic diagram illustrating a communication framework of the system for semantic communication with networked AI in 6G, according to some embodiments of the present disclosure.
FIGS. 4A and 4B are exemplary flow diagram illustrating a processor-implemented method for semantic communication with networked AI in sixth-generation technology for wireless communications (6G), according to some embodiments of the present disclosure.
FIG. 5 is a notional architecture diagram of the proposed semantic communication powered tele-avatar based live remote teaching, according to some embodiments of the present disclosure.
FIG. 6 is a block diagram illustrating a visual AI based pipeline for semantic extraction and prediction, according to some embodiments of the present disclosure.
FIG. 7 is an overall architecture illustrating a semantic communication and GenAI based live remote disaster tracking, according to some embodiments of the present disclosure.

### DETAILED DESCRIPTION OF EMBODIMENTS

Exemplary embodiments are described with reference to the accompanying drawings. In the figures, the left-most digit(s) of a reference number identify the figure in which the reference number first appears. Wherever convenient, the same reference numbers are used throughout the drawings to refer to the same or like parts. While examples and features of disclosed principles are described herein, modifications, adaptations, and other implementations are possible without departing from the scope of the disclosed embodiments.

6G promises a lot of exciting futuristic delay-sensitive low-latency interactive applications including extended reality (XR), robotics with embodied intelligence, intelligent IoT systems, etc. However, it is apprehended that the volume of data, especially for XR kind of applications, may become unmanageable by the ICT infrastructure and this will cause a severe degradation in latency contrary to the low-latency requirements. Also, given the data flow requirements of promised applications, it seems that the capacity needed by a communication channel may get severely constrained by Shannon's information theoretic limit.

However, over the years, artificial intelligence (AI) and machine learning (ML) has significantly evolved in terms of massively learning the attributes of different types of inputs, churning out relevant inference from a given input and, also, to predict outputs according to the inferences. Furthermore, 6G promises the future network to natively support AI functions as part of the AI native network (AINN) initiatives. This has renewed interest in addressing the problem of communication from the semantic aspects. This has led to the paradigm of semantic communication (SemCom). It is imperative that the paradigm of *SemCom* depends heavily on AI/ML algorithms both in the transmitter (for feature extraction & inferring the relevant semantic knowledge) and the receiver side (for output prediction). Such systems also need to heavily depend on the supplied knowledge models dedicated to the given task. This paradigm is also termed as *task-oriented* communication.

Embodiments herein provide a method and system for a semantic communication with networked AI in sixth-generation technology for wireless communications (6G). Here, rather than encoding the input and transmitting the encoded symbols, the semantically relevant information is inferred from the input as per the context of the application and that information is encoded through conventional source encoding and transmitted. Conversion of the actual input to semantic information allows a huge reduction in the bandwidth requirement for the end-to-end channel. On the receiver side, these symbols are first decoded to extract semantic information. The semantic information is further used to predict the semantically relevant output to carry out the intended meaning at the receiver side. The accuracy of the system is indicated by the semantic noise which indicates how much the predicted output at the receiver side has deviated from the intended relevant message. It is imperative that the paradigm of SemCom depends heavily on AI/ML algorithms both in the transmitter (for feature extraction & inferring the relevant semantic knowledge) and the receiver side (for output prediction). Such systems also need to heavily depend on the supplied knowledge models dedicated to the given task. This paradigm is also termed as task-oriented communication.

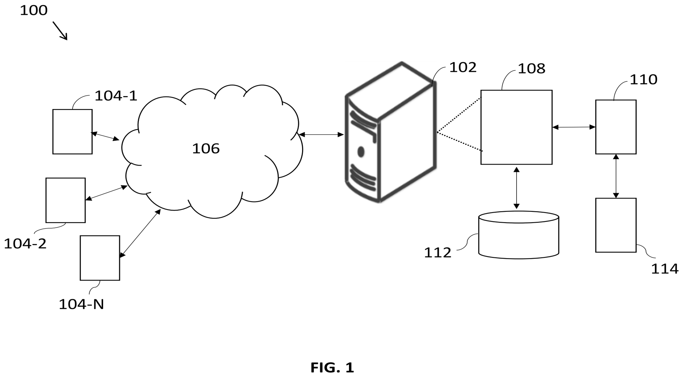

Referring now to the drawings, and more particularly to FIG. 1 through FIG. 7, where similar reference characters denote corresponding features consistently throughout the figures, there are shown preferred embodiments, and these embodiments are described in the context of the following exemplary system and/or method.

FIG. 1 illustrates a block diagram of a system 100 for a voice assisted defect logging and quality inspection, according to some embodiments of the present disclosure. Although the present disclosure is explained considering that the system 100 is implemented on a server, it may be understood that the system 100 may comprise one or more computing devices 102, such as a laptop computer, a desktop computer, a notebook, a workstation, a cloud-based computing environment and the like. It will be understood that the system 100 may be accessed through one or more input/output interfaces 104-1, 104-2... 104-N, collectively referred to as I/O interface 104. Examples of the I/O interface 104 may include, but are not limited to, a user interface, a portable computer, a personal digital assistant, a handheld device, a smartphone, a tablet computer, a workstation, and the like. The I/O interface 104 is communicatively coupled to the system 100 through a network 106.

In an embodiment, the network 106 may be a wireless or a wired network, or a combination thereof. In an example, the network 106 can be implemented as a computer network, as one of the different types of networks, such as virtual private network (VPN), intranet, local area network (LAN), wide area network (WAN), the internet, and such. The network 106 may either be a dedicated network or a shared network, which represents an association of the different types of networks that use a variety of protocols, for example, Hypertext Transfer Protocol (HTTP), Transmission Control Protocol/Internet Protocol (TCP/IP), and Wireless Application Protocol (WAP), to communicate with each other. Further, the network 106 may include a variety of network devices, including routers, bridges, servers, computing devices, storage devices. The network devices within the network 106 may interact with the system 100 through communication links.

The system 100 supports various connectivity options such as BLUETOOTH^{®}, USB, ZigBee, and other cellular services. The network environment enables connection of various components of the system 100 using any communication link including Internet, WAN, MAN, and so on. In an exemplary embodiment, the system 100 is implemented to operate as a stand-alone device. In another embodiment, the system 100 may be implemented to work as a loosely coupled device to a smart computing environment. Further, the system 100 comprises at least one memory 110 with a plurality of instructions, one or more databases 112, and one or more hardware processors 108 which are communicatively coupled with the at least one memory to execute a plurality of modules 114 therein. The components and functionalities of the system 100 are described further in detail.

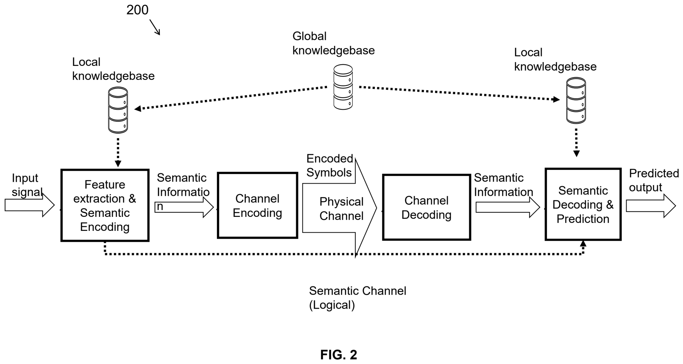

FIG. 2 is a functional block diagram 200 to illustrate the system 100 for a generic semantic communication, according to some embodiments of the present disclosure. In one embodiment, the system 100 is configured for a semantic communication (SemCom) with networked AI in sixth-generation technology for wireless communications (6G). A user equipment (UE) sends a connection request to the application server through an Edge. The UE is associated with a camera. The UE captures the images/videos at a transmitter side and sends them to the edge. Then, the edge is responsible for further processing. Herein, the edge can be any end-device such as mobile. It is to be noted that the UE and the edge are different. The UE is a power-constrained and computationally constrained.

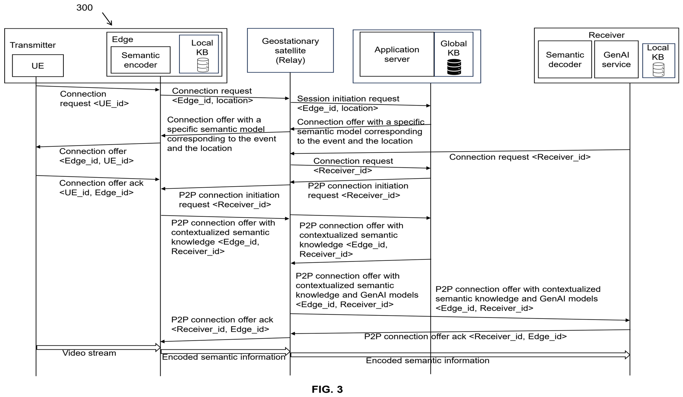

The request is forwarded to the application server with a semantic decoder through a satellite relay. A connection is established between the application server and the edge. The receiving unit (already connected to a GenAI service) also sends connection request to the application server. The application server gets the location information from the connection request from the edge. The application server shares a smaller knowledge base corresponding to the given location with the edge and the Gen AI service at the receiving unit. A sequence diagram depicting the communication between various components of the semantic communication as shown in FIG. 3.

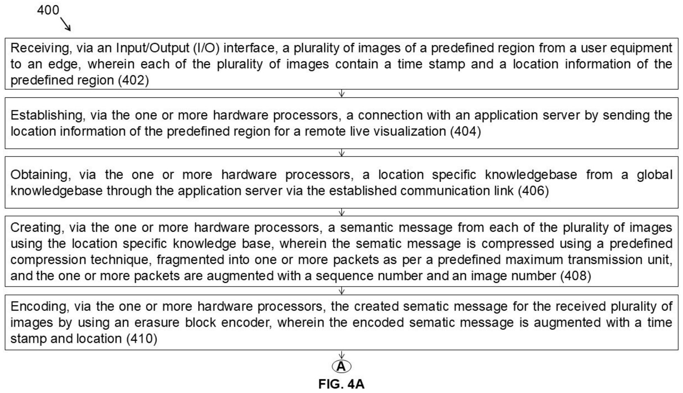

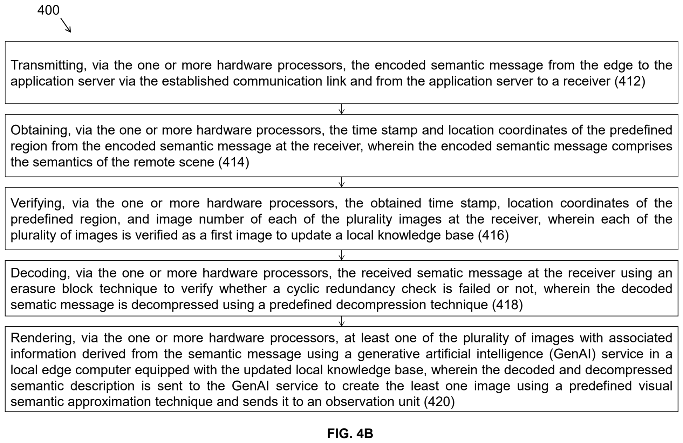

FIGS. 4A and 4B are flow diagram illustrating a processor-implemented method 400 for the dynamic prediction of component-wise biomass saturation using non-invasive sensing implemented by the system 100 of FIG. 1, in accordance with an embodiment of the present disclosure. Functions of the components of the system 100 are now explained through steps of flow diagram in FIGS. 4A and 4B, according to some embodiments of the present disclosure. In the method and system for a semantic communication (SemCom) with networked AI in sixth-generation technology for wireless communications (6G).

Initially, at step 402 of the processor-implemented method 400, the one or more hardware processors 108 are configured by the programmed instructions to receive a plurality of images of a predefined region from a user equipment to an edge. Each of the plurality of images comprises a time stamp and a location information of the predefined region. A user equipment (UE) sends a connection request to the application server through an Edge. The UE is associated with a camera. The UE captures the images/videos at a transmitter side and sends them to the edge. Then, the edge is responsible for further processing. Herein, the edge can be any end-device such as mobile. It is to be noted that the UE and the edge are different. The UE is a power-constrained and computationally constrained.

At the next step 404 of the processor-implemented method 400, the one or more hardware processors 108 are configured by the programmed instructions to establish a connection with an application server by sending the location information of the predefined region for a remote live visualization. The edge is establishing the connection with the application server. The UE is connected to the edge not directly to the application server.

At the next step 406 of the processor-implemented method 400, the one or more hardware processors 108 are configured by the programmed instructions to obtain a location specific knowledgebase from a global knowledgebase through the application server via the established communication link.

At the next step 408 of the processor-implemented method 400, the one or more hardware processors 108 are configured by the programmed instructions to create a semantic message from each of the plurality of images using the location specific knowledge base using predefined techniques such as scene-graph generation technique and parametric motion estimation technique. The sematic message is compressed using a predefined compression technique, fragmented into one or more packets as per a predefined maximum transmission unit, and the one or more packets are augmented with a sequence number and an image number.

At the next step 410 of the processor-implemented method 400, the one or more hardware processors 108 are configured by the programmed instructions to encode the created sematic message for the received plurality of images by using an erasure block encoder. The encoded sematic message is augmented with a time stamp and location. The semantically relevant information is inferred from the input as per the context of the application and that information is encoded through conventional source encoding and transmitted.

At the next step 412 of the processor-implemented method 400, the one or more hardware processors 108 are configured by the programmed instructions to transmit the encoded semantic message from the edge to the application server via the established communication link and from the application server to a receiver. Herein, one or more layers of an Artificial neural network (ANN) model are computed at the endpoint depending on the condition of the channel and the node

At the next step 414 of the processor-implemented method 400, the one or more hardware processors 108 are configured by the programmed instructions to obtain the time stamp and location coordinates of the predefined region from the encoded semantic message at the receiver. The encoded semantic message comprises the semantics of the remote scene.

At the next step 416 of the processor-implemented method 400, the one or more hardware processors 108 are configured by the programmed instructions to verify the obtained time stamp, location coordinates of the predefined region, and image number of each of the plurality images at the receiver. Each of the plurality of images is verified as a first image to update a local knowledge base. The local knowledge base is updated with a geographical, a demographical and the stored image data for the given location coordinate from a global knowledge base by querying global knowledgebase for the information tagged to the location received from a transmitter.

At the next step 418 of the processor-implemented method 400, the one or more hardware processors 108 are configured by the programmed instructions to decode the received sematic message at the receiver using an erasure block technique to verify whether a cyclic redundancy check is failed or not. The decoded sematic message is decompressed using a predefined decompression technique.

Finally, at the last step 420 of the processor-implemented method 400, the one or more hardware processors 108 are configured by the programmed instructions to render at least one of the plurality of images with associated information derived from the semantic message using a generative artificial intelligence (GenAI) service in a local edge computer equipped with the updated local knowledge base. Wherein, the decoded and decompressed semantic description is sent to the GenAI service to create the least one image using a predefined visual semantic approximation technique and sends it to an observation unit.

### Experiments:

Use case 1 *- Futuristic Remote Teaching in Rural School by Live '3D Tele-avatar' using 'Semantic Live Streaming' -* As India leapfrogs to future, equipment like augmented reality (AR) and virtual reality (VR) glasses are being embraced in future roadmap of education powered by AR/VR. To bring in the traditional teacher-student live interaction, one exciting application would be if a remote expert teacher could be virtually present live in the class in 3D. Students can interact with the teacher's live 3D avatar in real-time and the teacher also can respond remotely through that 3D avatar. *3D holoportation* based deployments are infeasible both in terms of practical scalable deployments in schools and teachers' premises, and the bandwidth requirements.

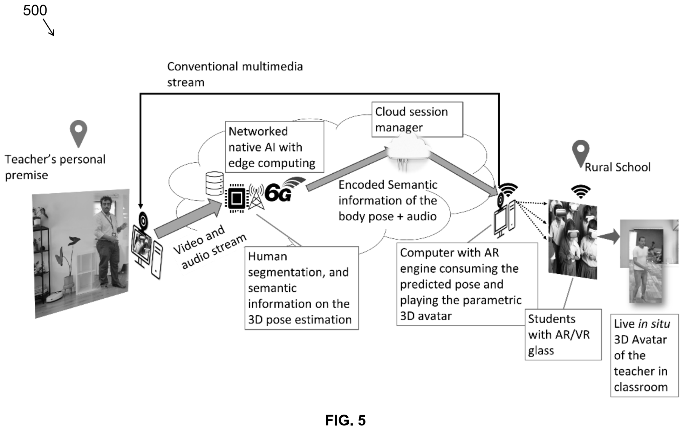

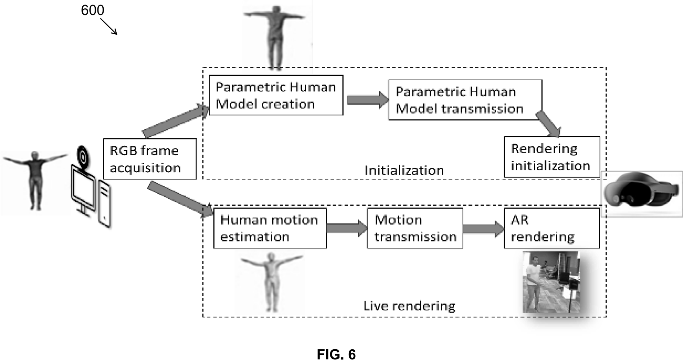

FIG. 5 an overall architecture diagram of the semantic communication powered tele-avatar based live remote teaching, according to some embodiments of the present disclosure. Herein, a teacher stands in front of a simple RGB camera attached to a computer which streams live visuals and audio of the teacher to an edge computer natively integrated with the 6G network service. The edge computer is equipped with AI algorithm which segments the teacher's body from the instantaneous visuals captured by the camera and identifies the teacher's 3D body posture in real-time at a specified framerate. The live output of the AI algorithm is encoded as semantic information of the body pose and transmitted over the network to the remote school's computing device which is connected to the virtual reality (VR) glasses of the students. The computing device at the school has a local augmented reality (AR) engine which is preloaded with a parametric three-dimensional (3D) avatar of the teacher. The semantic information of the live body posture received by the computing device in the school is decoded and the predicted body posture is transferred to the 3D avatar. As an effect, each student sees the remote teacher's avatar in situ as if the teacher is present in the classroom as a *'Semantic Live Streaming'* as shown in FIG. 6. Since the teacher does not need to see the students in 3D, a camera attached to the computing device in the school can transmit back the view of the class to the teacher through conventional real-time streaming. Since the 3D avatar is practically controlled live by the gestures of the remote teacher, such avatars can be known as *tele-avatar.*

Use 2 *- Remote Visual Tracking Using Semantic Scene Understanding and GenAI-based Predictive Rendering -* In case of massive disaster (like flood) over a vast area, the terrestrial cellular connectivity may get destroyed. This jeopardizes the ability of remote instantaneous visual tracking of the disaster site by the central control room. An alternative might be that a local first responded team transmits the visuals from the disaster sight using geostationary (GEO) satellite backhaul from the rescue boat. But such satellite based long haul has huge latency and may not provide enough bandwidth. Sharing high-definition video and images over such a link in real-time may not be practically possible.

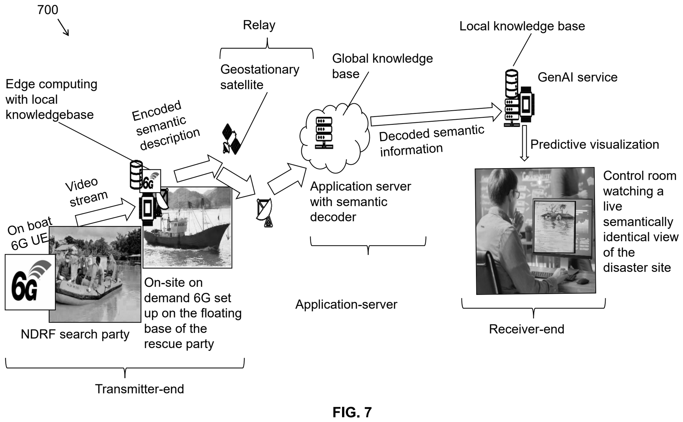

FIG. 7 a schematic diagram illustrating a semantic communication and GenAI based live remote disaster tracking, according to some embodiments of the present disclosure. In this case a private 6G set up with non-terrestrial backbone is installed on the floating base of the recue party. The base is equipped with an antenna connected to the control unit through GEO. The rescue party roams around in a small boat equipped with 6G user equipment (UE) which captures the live visuals and transmits to the base unit edge computing service. The semantic encoder residing in the edge computer extracts the relevant scene understanding and creates a semantic description against each visual. The encoded semantic information demands much less bandwidth compared to transmission of the full video or the image and can be transmitted over the GEO backhaul much quicker with reliability. The decoded semantic information may either be directly consumed by the control station, or it can be fed to a GenAI server with local knowledge base to predictively recreate a scene corresponding to the received semantics. If low semantic noise is ensured, then such a system can provide efficient remote visualization of disaster sites.

The written description describes the subject matter herein to enable any person skilled in the art to make and use the embodiments. The scope of the subject matter embodiments is defined by the claims and may include other modifications that occur to those skilled in the art. Such other modifications are intended to be within the scope of the claims if they have similar elements that do not differ from the literal language of the claims or if they include equivalent elements with insubstantial differences from the literal language of the claims.

The embodiments of the present disclosure herein address unresolved problems of communication from the semantic aspects. Embodiments herein provide a method and system for a semantic communication with networked AI in sixth-generation technology for wireless communications (6G). Here, rather than encoding the input and transmitting the encoded symbols, the semantically relevant information is inferred from the input as per the context of the application and that information is encoded through conventional source encoding and transmitted. Conversion of the actual input to semantic information allows a huge reduction in the bandwidth requirement for the end-to-end channel. On the receiver side, these symbols are first decoded to extract semantic information. The semantic information is further used to predict the semantically relevant output to carry out the intended meaning at the receiver side.

It is to be understood that the scope of the protection is extended to such a program and in addition to a computer-readable means having a message therein; such computer-readable storage means comprises of program-code means for implementation of one or more steps of the method, when the program runs on a server or mobile device or any suitable programmable device. The hardware device can be any kind of device which can be programmed including e.g., any kind of computer like a server or a personal computer, or the like, or any combination thereof. The device may also include means which could be e.g., hardware means like e.g., an application-specific integrated circuit (ASIC), a field-programmable gate array (FPGA), or a combination of hardware and software means, e.g., an ASIC and an FPGA, or at least one microprocessor and at least one memory with software processing components located therein. Thus, the means can include both hardware means, and software means. The method embodiments described herein could be implemented in hardware and software. The device may also include software means. Alternatively, the embodiments may be implemented on different hardware devices, e.g., using a plurality of CPUs.

The embodiments herein can comprise hardware and software elements. The embodiments that are implemented in software include but are not limited to, firmware, resident software, microcode, etc. The functions performed by various components described herein may be implemented in other components or combinations of other components. For the purposes of this description, a computer-usable or computer readable medium can be any apparatus that can comprise, store, communicate, propagate, or transport the program for use by or in connection with the instruction execution system, apparatus, or device.

The illustrated steps are set out to explain the exemplary embodiments shown, and it should be anticipated that ongoing technological development will change the manner in which particular functions are performed. These examples are presented herein for purposes of illustration, and not limitation. Further, the boundaries of the functional building blocks have been arbitrarily defined herein for the convenience of the description. Alternative boundaries can be defined so long as the specified functions and relationships thereof are appropriately performed. Alternatives (including equivalents, extensions, variations, deviations, etc., of those described herein) will be apparent to persons skilled in the relevant art(s) based on the teachings contained herein. Such alternatives fall within the scope of the disclosed embodiments. Also, the words "comprising," "having," "containing," and "including," and other similar forms are intended to be equivalent in meaning and be open ended in that an item or items following any one of these words is not meant to be an exhaustive listing of such item or items or meant to be limited to only the listed item or items. It must also be noted that as used herein and in the appended claims, the singular forms "a," "an," and "the" include plural references unless the context clearly dictates otherwise.

Furthermore, one or more computer-readable storage media may be utilized in implementing embodiments consistent with the present disclosure. A computer-readable storage medium refers to any type of physical memory on which information or data readable by a processor may be stored. Thus, a computer-readable storage medium may store instructions for execution by one or more processors, including instructions for causing the processor(s) to perform steps or stages consistent with the embodiments described herein. The term "computer-readable medium" should be understood to include tangible items and exclude carrier waves and transient signals, i.e., be non-transitory. Examples include random access memory (RAM), read-only memory (ROM), volatile memory, nonvolatile memory, hard drives, CD ROMs, DVDs, flash drives, disks, and any other known physical storage media.

It is intended that the disclosure and examples be considered as exemplary only, with a true scope of disclosed embodiments being indicated by the following claims.

## Claims

1. A processor-implemented method (400) comprising:
receiving (402), via an Input/Output (I/O) interface, a plurality of images of a predefined region from a user equipment to an edge, wherein each of the plurality of images comprises of a time stamp and a location information of the predefined region;
establishing (404), via the one or more hardware processors, a connection with an application server by sending the location information of the predefined region for a remote live visualization;
obtaining (406), via the one or more hardware processors, a location specific knowledgebase from a global knowledgebase through the application server via the established communication link;
creating (408), via the one or more hardware processors, a semantic message from each of the plurality of images using the location specific knowledge base, wherein the sematic message is compressed using a predefined compression technique, fragmented into one or more packets as per a predefined maximum transmission unit, and the one or more packets are augmented with a sequence number and an image number;
encoding (410), via the one or more hardware processors, the created sematic message for the received plurality of images by using an erasure block encoder, wherein the encoded sematic message is augmented with a time stamp and location;
transmitting (412), via the one or more hardware processors, the encoded semantic message from the edge to the application server via the established communication link and from the application server to a receiver;
obtaining (414), via the one or more hardware processors, the time stamp and location coordinates of the predefined region from the encoded semantic message at the receiver, wherein the encoded semantic message comprises the semantics of the remote scene;
verifying (416), via the one or more hardware processors, the obtained time stamp, location coordinates of the predefined region, and image number of each of the plurality images at the receiver, wherein each of the plurality of images is verified as a first image to update a local knowledge base;
decoding (418), via the one or more hardware processors, the received sematic message at the receiver using an erasure block technique to verify whether a cyclic redundancy check is failed or not, wherein the decoded sematic message is decompressed using a predefined decompression technique; and
rendering (420), via the one or more hardware processors, at least one of the plurality of images with associated information derived from the semantic message using a generative artificial intelligence (GenAI) service in a local edge computer equipped with the updated local knowledge base, wherein the decoded and decompressed semantic description is sent to the GenAI service to create the least one image using a predefined visual semantic approximation technique and sends it to an observation unit.

2. The processor-implemented method (400) as claimed in claim 1, wherein the semantically relevant information is inferred from the input as per the context of the application and that information is encoded through conventional source encoding and transmitted.

3. The processor-implemented method (400) as claimed in claim 1, wherein one or more layers of an artificial neural network (ANN) are computed at the endpoint depending on the condition of the channel and the node.

4. The processor-implemented method (400) as claimed in claim 1, wherein the local knowledge base is updated with a geographical, a demographical and the stored image data for the given location coordinate from a global knowledge base by querying global knowledgebase for the information tagged to the location received from a transmitter.

5. A system (100) comprising:
a memory (110) storing instructions;
one or more Input/Output (I/O) interfaces (104); and
one or more hardware processors (108) coupled to the memory (110) via the one or more I/O interfaces (104), wherein the one or more hardware processors (108) are configured by the instructions to:
receive a plurality of images of a predefined region from a user equipment to an edge, wherein each of the plurality of images comprises of a time stamp and a location information of the predefined region;
establish a connection with an application server by sending the location information of the predefined region for a remote live visualization;
obtain a location specific knowledgebase from a global knowledgebase through the application server via the established communication link;
create a semantic message from each of the plurality of images using the location specific knowledge base, wherein the sematic message is compressed using a predefined compression technique, fragmented into one or more packets as per a predefined maximum transmission unit, and the one or more packets are augmented with a sequence number and an image number;
encode the created sematic message for the received plurality of images by using an erasure block encoder, wherein the encoded sematic message is augmented with a time stamp and location;
transmit the encoded semantic message from the edge to the application server via the established communication link and from the application server to a receiver;
obtain the time stamp and location coordinates of the predefined region from the encoded semantic message at the receiver, wherein the encoded semantic message comprises the semantics of the remote scene;
verify the obtained time stamp, location coordinates of the predefined region, and image number of each of the plurality images at the receiver, wherein each of the plurality of images is verified as a first image to update a local knowledge base;
decode the received sematic message at the receiver using an erasure block technique to verify whether a cyclic redundancy check is failed or not, wherein the decoded sematic message is decompressed using a predefined decompression technique; and
render at least one of the plurality of images with associated information derived from the semantic message using a generative artificial intelligence (GenAI) service in a local edge computer equipped with the updated local knowledge base, wherein the decoded and decompressed semantic description is sent to the GenAI service to create the least one image using a predefined visual semantic approximation technique and sends it to an observation unit.

6. The system (100) as claimed in claim 5, wherein the semantically relevant information is inferred from the input as per the context of the application and that information is encoded through conventional source encoding and transmitted.

7. The system (100) as claimed in claim 5, wherein one or more layers of an artificial neural network (ANN) are computed at the endpoint depending on the condition of the channel and the node.

8. The system (100) as claimed in claim 5, wherein the local knowledge base is updated with a geographical, a demographical and the stored image data for the given location coordinate from a global knowledge base by querying global knowledgebase for the information tagged to the location received from a transmitter.

9. One or more non-transitory machine-readable information storage mediums comprising one or more instructions which when executed by one or more hardware processors cause:
receiving, via an Input/Output (I/O) interface, a plurality of images of a predefined region from a user equipment to an edge, wherein each of the plurality of images comprises of a time stamp and a location information of the predefined region;
establishing a connection with an application server by sending the location information of the predefined region for a remote live visualization;
obtaining a location specific knowledgebase from a global knowledgebase through the application server via the established communication link;
creating a semantic message from each of the plurality of images using the location specific knowledge base, wherein the sematic message is compressed using a predefined compression technique, fragmented into one or more packets as per a predefined maximum transmission unit, and the one or more packets are augmented with a sequence number and an image number;
encoding the created sematic message for the received plurality of images by using an erasure block encoder, wherein the encoded sematic message is augmented with a time stamp and location;
transmitting the encoded semantic message from the edge to the application server via the established communication link and from the application server to a receiver;
obtaining the time stamp and location coordinates of the predefined region from the encoded semantic message at the receiver, wherein the encoded semantic message comprises the semantics of the remote scene;
verifying the obtained time stamp, location coordinates of the predefined region, and image number of each of the plurality images at the receiver, wherein each of the plurality of images is verified as a first image to update a local knowledge base;
decoding the received sematic message at the receiver using an erasure block technique to verify whether a cyclic redundancy check is failed or not, wherein the decoded sematic message is decompressed using a predefined decompression technique; and
rendering at least one of the plurality of images with associated information derived from the semantic message using a generative artificial intelligence (GenAI) service in a local edge computer equipped with the updated local knowledge base, wherein the decoded and decompressed semantic description is sent to the GenAI service to create the least one image using a predefined visual semantic approximation technique and sends it to an observation unit.

10. The one or more non-transitory machine-readable information storage mediums as claimed in claim 9, wherein the semantically relevant information is inferred from the input as per the context of the application and that information is encoded through conventional source encoding and transmitted.

11. The one or more non-transitory machine-readable information storage mediums as claimed in claim 9, wherein one or more layers of an artificial neural network (ANN) are computed at the endpoint depending on the condition of the channel and the node.

12. The one or more non-transitory machine-readable information storage mediums as claimed in claim 9, wherein the local knowledge base is updated with a geographical, a demographical and the stored image data for the given location coordinate from a global knowledge base by querying global knowledgebase for the information tagged to the location received from a transmitter.
